Europäisches Patentamt

European Patent Office

Office européen des brevets

(11) Veröffentlichungsnummer: **0 439 653 A1**

## (12) EUROPÄISCHE PATENTANMELDUNG

(21) Anmeldenummer: 90101916.6

(22) Anmeldetag: 31.01.90

(51) Int. Cl.5: **H01L 23/66**, H01L 23/495

(43) Veröffentlichungstag der Anmeldung:
07.08.91 Patentblatt 91/32

(84) Benannte Vertragsstaaten:
AT BE CH DE DK ES FR GB GR IT LI LU NL SE

(71) Anmelder: **Siemens Aktiengesellschaft**
**Wittelsbacherplatz 2**
**W-8000 München 2(DE)**

(72) Erfinder: **Hargasser, Hans, Dipl.-Ing. (FH)**
**Salzmannstrasse 46**
**W-8000 München 83(DE)**

(54) Hochfrequenz-SMD-Transistor mit zwei Emitteranschlüssen.

(57) Ein Hochfrequenz-SMD-Transistor mit zwei Emitteranschlüssen, bei dem ein Halbleitertransistor-Chip (6) auf einem Leiterband (9) befestigt und mit elektrischen Anschlüssen (1 bis 4) auf dem Leiterband (9) kontaktiert ist, soll kleinste Halbleiter-Chip-Abmessungen bei hoher Zuverlässigkeit ermöglichen. Die beiden Emitteranschlüsse des Hochfrequenz-SMD-Transistors sind innerhalb des Leiterbands (9) einstückig ausgebildet. Zwischen dem Emitterkontakt des Halbleiter-Transistor-Chips (6) und den einstückig ausgebildeten beiden Emitteranschlüssen ist eine einzige elektrische Verbindung (7) vorhanden.

FIG 12

EP 0 439 653 A1

## HOCHFREQUENZ-SMD-TRANSISTOR MIT ZWEI EMITTERANSCHLÜSSEN

Die Erfindung betrifft einen Hochfrequenz-SMD-Transistor mit zwei Emitteranschlüssen nach dem Oberbegriff des Patentanspruchs 1 und ein Leiterband (Lead Frame) nach dem Oberbegriff des Patentanspruchs 5.

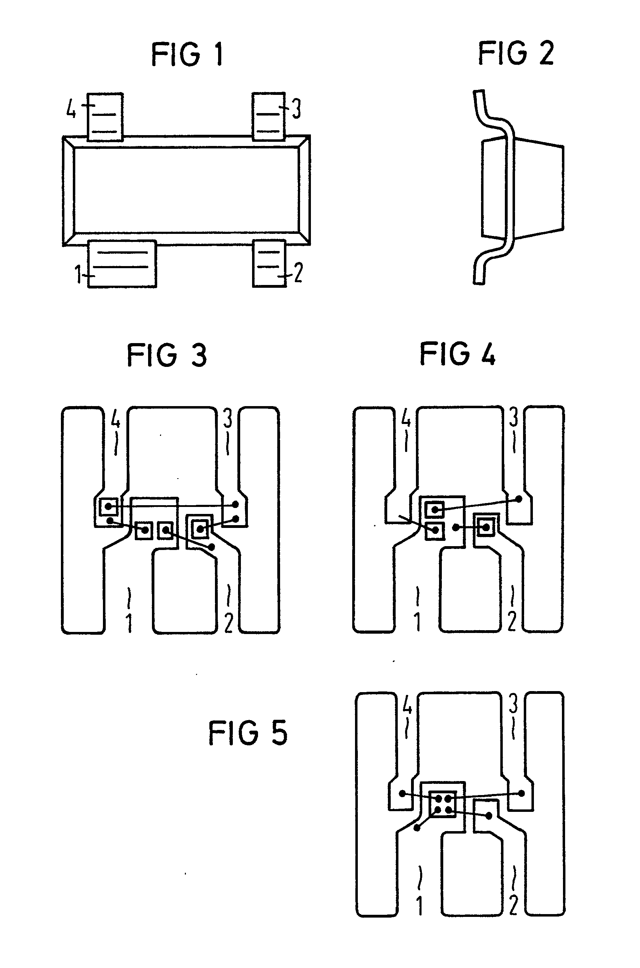

Insbesondere bezieht sich die Erfindung auf die SMD (SMD = surface mounted device)-Bauform SOT-143 nach FIG 1 und 2. FIG 1 zeigt dabei eine Draufsicht auf ein SMD-Bauelement der Bauform SOT-143. FIG 2 zeigt eine Teilansicht eines elektronischen Bauelements nach FIG 1.

In FIG 1 bezeichnen die Bezugszeichen 1 bis 4 elektrische Anschlüsse des SMD-Bauelements. Der elektrische Anschluß (PIN) 1 bezeichnet dabei üblicherweise den Kollektor. Der elektrische Anschluß 4 bezeichnet üblicherweise einen Emitter-Anschluß. Bei einer ersten Ausführungsform des SMD-Bauelements können der elektrische Anschluß 2 einen weiteren Emitter-Anschluß und der elektrische Anschluß 3 einen Basisanschluß bezeichnen. Bei einer zweiten Ausführungsform des SMD-Bauelements können der elektrische Anschluß 2 einen Basis-Anschluß und der elektrische Anschluß 3 einen weiteren Emitter-Anschluß bezeichnen.

Bipolare Hochfrequenz-Breitband-Transistoren erreichen in der Bauform SOT-143 mit vier elektrischen Anschlüssen 1 bis 4 im Vergleich zur SMD-Bauform SOT-23, welche nur drei elektrische Anschlüsse besitzt, deutlich größere Verstärkung bei hohen Frequenzen wegen verringerter Emitter-Zuleitungs-Induktivität und wegen verringerter kapazitiver Kopplung zwischen dem Kollektor und der Basis.

Bei den bekannten Hochfrequenz-SMD-Transistoren mit zwei Emitteranschlüssen sitzt ein Halbleiter-Transistor-Chip auf dem Leiterband. Dieser Halbleiter-Transistor-Chip ist üblicherweise mit den beiden Emitter-Anschlüssen des SMD-Bauelements über zwei elektrische Bonddrähte elektrisch verbunden.

FIG 3 bis 11 zeigen Anwendungsbeispiele verschiedener Halbleiter-Chips in Verbindung mit Standard-Leiterbändern. Bei diesen Anwendungsbeispielen der FIG 3 bis 11 entstehen jeweils elektronische SMD-Bauelemente mit jeweils vier elektrischen Anschlüssen 1 bis 4. Bei FIG 3 sind auf dem elektrischen Anschluß 1 zwei Halbleiter-Chips und auf den elektrischen Anschlüssen 2 und 4 jeweils ein Halbleiter-Chip befestigt. Bei FIG 4 sind auf dem elektrischen Anschluß 1 zwei Halbleiter-Chips und auf dem elektrischen Anschluß 2 ein Halbleiter-Chip befestigt. Bei FIG 5 ist ein einziger Halbleiter-Chip auf dem elektrischen Anschluß 1 befestigt. Dieser einzige Halbleiter-Chip ist über Bonddrähte mit den elektrischen Anschlüssen 2 bis 4 kontaktiert. Bei FIG 6 sind auf den elektrischen Anschlüssen 1 und 2 jeweils ein einziger Halbleiter-Chip befestigt. Bei FIG 7 sind auf den elektrischen Anschlüssen 3 und 4 jeweils ein einziger Halbleiter-Chip befestigt. FIG 8 zeigt ein Leiterband mit den elektrischen Anschlüssen 1 bis 4 vor der Befestigung und Kontaktierung von Halbleiter-Chips auf diesem Leiterband.

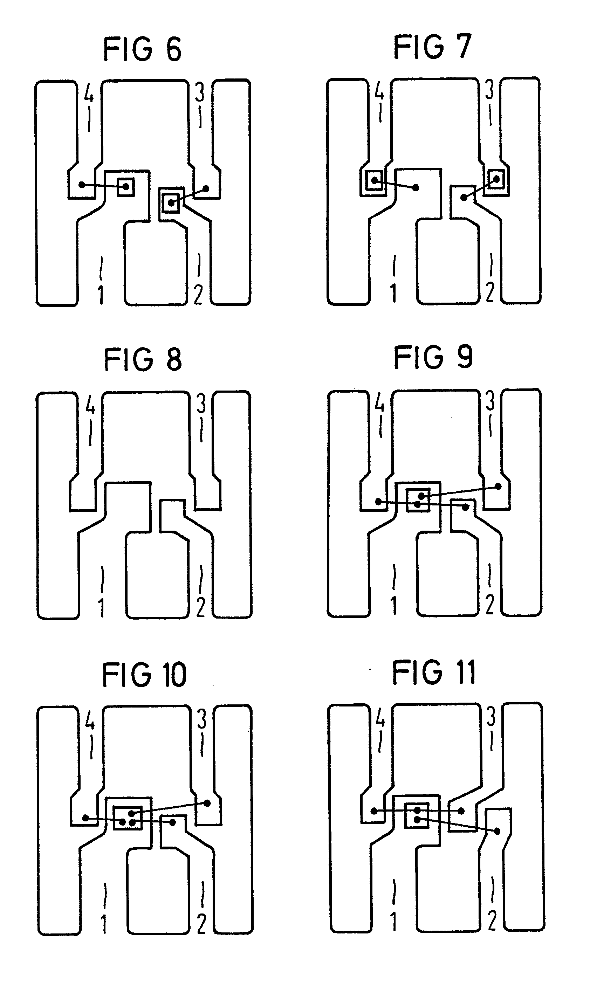

FIG 9 bis 11 zeigen drei Anwendungsbeispiele, bei denen jeweils ein einziger Halbleiter-Chip auf dem elektrischen Anschluß 1 befestigt ist. In den drei Anwendungsbeispielen der FIG 9 bis 11 werden jeweils zwei Bonddrähte zur Kontaktierung des Halbleiter-Chips mit zwei Emitter-Anschlüssen des SMD-Bauelements verwendet. Bei diesen drei Anwendungsbeispielen nach den FIG 9 bis 11 werden bei den fertigen SMD-Bauelementen jeweils zwei elektrische Emitter-Anschlüsse aus der Umhüllung des fertigen SMD-Bauelements herausgeführt.

Bei FIG 9 bilden die beiden elektrischen Anschlüsse 2 und 4 jeweils Emitter-Anschlüsse. Der Halbleiter-Chip ist mit den beiden elektrischen Anschlüssen 2 und 4 z. B. mit einem "Doppel-Nailhead" kontaktiert. Bei dem Anwendungsbeispiel nach FIG 10 besitzt der Halbleiter-Chip zwei Emitter-Kontaktierflecken. Diese beiden Emitter-Kontaktierflecken sind jeweils mit einem der beiden Emitter-Anschlüsse 2, 4 über Bonddrähte elektrisch verbunden. Bei dem Anwendungsbeispiel nach FIG 11 ist der Halbleiter-Chip mit den beiden Emitter-Anschlüssen 3, 4 über zwei Bonddrähte mittels Doppel-Nailhead-Verfahren elektrisch verbunden.

Das Verfahren, gemäß den FIG 9 und 11 auf dem Halbleiter-Chip zwei Nailheads aufeinander zu pressen, ist bei schnell laufenden Kontaktierautomaten umso kritischer, je kleiner die Kontaktierflächen bzw. die Drahtdurchmesser gewählt werden. Beim Anwendungsbeispiel nach FIG 10 können die beiden Kontaktierflecken, die auf dem Halbleiter-Chip nebeneinander angeordnet sind, verfahrenstechnisch einwandfrei kontaktiert werden. Die beiden Kontaktierflecken müssen jedoch in einem bestimmten Abstand zueinander angeordnet sein, was zu einer Vergrößerung der Halbleiter-Chip-Abmessungen und damit zu einer Kostensteigerung führt. Dazu kommt noch der negative Einfluß der Kollektor-Emitter-Kapazität der Kontaktierflecken auf die Verstärkung des SMD-Bauelements im Bereich hoher Frequenzen, beispielsweise im Bereich von zwei Gigahertz.

Der vorliegenden Erfindung liegt daher die Aufgabe zugrunde, einen Hochfrequenz-SMD-Transistor der eingangs genannten Art und ein Leiterband der eingangs genannten Art anzugeben, die kleinste Halbleiter-Chip-Abmessungen bei hoher Zuverlässigkeit ermöglichen.

Diese Aufgabe wird erfindungsgemäß durch einen Hochfrequenz-SMD-Transistor nach dem Patentanspruch 1 und durch ein Leiterband nach dem Patentanspruch 5 gelöst.

Ausgestaltungen und Vorteile der Erfindung sind in den Unteransprüchen, der Beschreibung und der Zeichnung angegeben.

Die Erfindung ermöglicht eine "Eindraht-Lösung" im Vergleich zu der Zweidraht-Lösung mit z. B. dem Doppel-Nailhead-Verfahren oder mit einem anderen Kontaktierungsverfahren gemäß FIG 9 und 11.

Die Eindraht-Lösung nach der Erfindung ist gekennzeichnet durch eine Verbindung der beiden Emitter-Pins innerhalb des Leiterbands aufgrund einer speziellen Stanzung dieses Leiterbands und durch den Anschluß des Emitters auf dem Halbleiter-Chip über einen einzigen Bonddraht zum Leiterband hin. Dieser einzige Bonddraht kann vorteilhafterweise eine relativ geringe Länge aufweisen und damit eine geringe Emitter-Zuleitungsinduktivität verursachen.

Vorteile der Eindraht-Lösung nach der Erfindung sind:
Niedrige Herstellkosten wegen Wegfall eines zweiten Bonddrahtes für die Emitter-Kontaktierung;
Ausbeutesteigerung im Vergleich zum Doppel-Nailhead-Verfahren nach FIG 9 und 11;
kleinste Halbleiter-Chip-Abmessungen sind möglich, nur ein einziger Kontaktierfleck für die Kontaktierung mit den Emitteranschlüssen ist erforderlich;
hohe Zuverlässigkeit des Herstellverfahrens und des fertigen SMD-Bauelements.

Die Erfindung wird anhand der Zeichnung näher erläutert.

FIG 1 und 2 zeigen die SMD-Bauform SOT-143 in Draufsicht und im der Seitensicht.

FIG 3 bis 11 zeigen verschiedene Anwendungsbeispiele mit verschiedenen Halbleiter-Chips in Verbindung mit Standard-Leiterbändern.

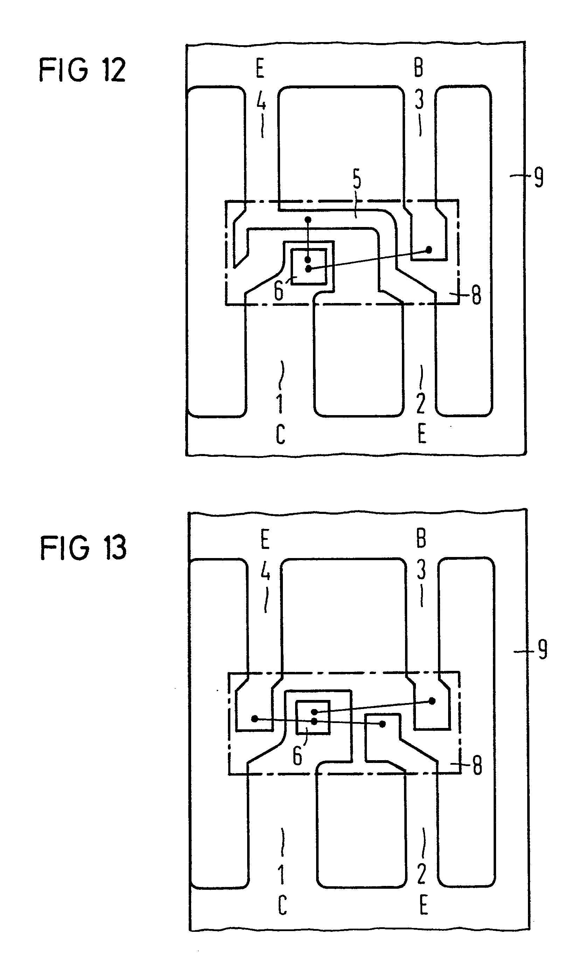

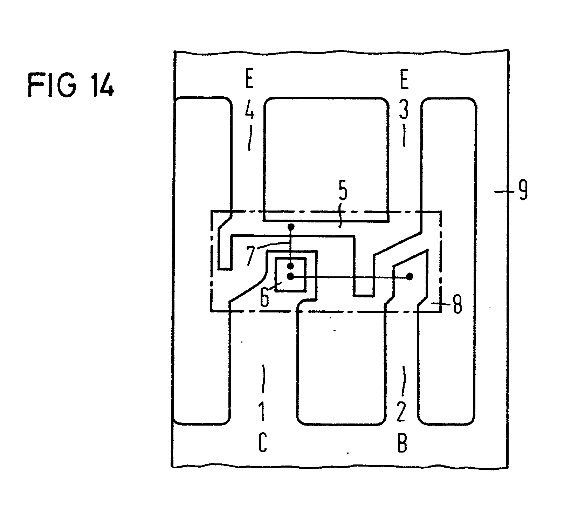

FIG 12 und 14 erläutern Ausführungsbeispiele der Erfindung. Flg 13 ermöglicht einen Vergleich des Ausführungsbeispiels nach der Erfindung gemäß FIG 12 mit einem anderen Anwendungsbeispiel. FIG 12 und 14 zeigen zwei Ausführungsbeispiele der Erfindung. Bei FIG 12 sind die beiden Emitter-Anschlüsse 2 und 4 im Inneren des Leiterbandes 9 miteinander über einen Steg 5 elektrisch leitend verbunden. Die elektrischen Anschlüsse 2 und 4 bilden zusammen mit dem Steg 5 ein durchgehendes Stück innerhalb des Leiterbandes 9. Der Halbleiterchip 6 ist auf dem elektrischen Anschluß 1 befestigt. Der Halbleiterchip 6 ist mittels eines Bonddrahtes mit dem Basisanschluß 3 elektrisch verbunden. Der Halbleiter-Chip 6 besitzt einen einzigen Emitter-Kontaktierfleck. Dieser einzige Emitter-Kontaktierfleck auf dem Halbleiter-Chip 6 ist über einen Bonddraht 7 von relativ geringer Länge mit dem Steg 5 zwischen den beiden Emitter-Anschlüssen 2 und 4 und somit gleichzeitig auch mit den beiden Emitter-Anschlüsse 2 und 4 elektrisch leitend verbunden. Das SMD-Bauelement erhält eine Umhüllung 8, vorzugsweise aus Plastik. Die elektrischen Anschlüsse 1 bis 4 werden schließlich vom Rahmen des Leiterbands 9 mechanisch getrennt und zu ihrer endgültigen Form gebogen. Beim Ausführungsbeispiel nach FIG 12 sind die beiden Emitteranschlüsse 2 und 4 diagonal gegenüberliegend angeordnet. FIG 14 zeigt ein weiteres Ausführungsbeispiel der Erfindung, bei dem dieselben Bezugszeichen wie in FIG 12 Einrichtungen mit denselben Funktionen bezeichnen. Beim Ausführungsbeispiel nach FIG 14 sind die beiden Emitter-Anschlüsse 3 und 4 nicht diagonal gegenüberliegend wie in FIG 12, sondern auf einer einzigen Längsseite der Umhüllung 8 des SMD-Bauelements herausgeführt. Auch beim Ausführungsbeispiel nach FIG 14 werden die obengenannten Vorteile der Erfindung realisiert. Auch beim Ausführungsbeispiel nach FIG 14 gibt es eine innere Verbindung der beiden Emitter-Anschlüsse 3 und 4 innerhalb des Leiterbands 9 und einen Anschluß des Emitters vom Halbleiter-Chip 6 zum Leiterband hin über einen einzigen Bonddraht 7.

FIG 13 verdeutlicht im Vergleich mit FIG 12 die Unterschiede zwischen einem Doppel-Nailhead-Verfahren und einer Eindraht-Lösung nach der Erfindung.

**Patentansprüche**

1. Hochfrequenz-SMD-Transistor mit zwei Emitteranschlüssen, bei dem ein Halbleitertransistor-Chip (6) auf einem Leiterband (9) befestigt und mit elektrischen Anschlüssen (1 bis 4) auf dem Leiterband (9) kontaktiert ist,
**gekennzeichnet durch** eine einstückige Ausbildung der beiden Emitteranschlüsse des Hochfrequenz-SMD-Transistors innerhalb des Leiterbands (9) und durch eine einzige elektrische Verbindung (7) zwischen dem Emitterkontakt des Halbleiter-Transistor-Chips (6) und den einstückig ausgebildeten beiden Emitteranschlüssen.

2. Hochfrequenz-SMD-Transistor nach Anspruch 1,
**gekennzeichnet durch** die SMD-Bauform SOT-143.

3. Hochfrequenz-SMD-Transistor nach Anspruch 1 oder 2,
**gekennzeichnet durch** diagonal gegenüberliegende Emitter-Pins (2, 4).

4. Hochfrequenz-SMD-Transistor nach Anspruch 1 oder 2,
**gekennzeichnet durch** auf einer einzigen Längsseite des SMD-Bauelements angeordnete Emitter-Pins (3, 4).

5. Leiterband (Lead Frame) für einen Hochfrequenz-SMD-Transistor mit zwei Emitteranschlüssen,
**gekennzeichnet durch** eine einstückige Ausbildung der beiden Emitteranschlüsse innerhalb des Leiterbands.

6. Leiterband nach Anspruch 5,
**gekennzeichnet durch** Verwendung für die SMD-Bauform SOT-143.

FIG 1

FIG 2

FIG 3

FIG 4

FIG 5

## FIG 6

## FIG 7

## FIG 8

## FIG 9

## FIG 10

## FIG 11

FIG 12

FIG 13

# FIG 14

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | GB-A-1 175 122 (PHILIPS ELECTRONIC AND ASSOCIATED INDUSTRIES LTD) * Spalte 1, Zeilen 9-21; Figuren 3,5,10; Spalte 2, Zeilen 1-39; Spalte 5, Zeile 123 - Spalte 6, Zeile 49; Spalte 8, Zeilen 12-30; Spalte 9, Zeilen 66-77 * | 1-3,5,6 | H 01 L 23/66 H 01 L 23/495 |
| Y | --- | 4 | |
| X | GB-A-1 137 619 (ITT INDUSTRIES INC.) * Seite 1, Zeilen 13-23; Figur 2; Seite 2, Zeilen 10-102 * | 1,3,5 | |
| A | --- NACHRICHTEN TECHNIK ELEKTRONIK, Band 37, Nr. 5, 1987, Seiten 169-174, Berlin, DD; H. GREINER: "Entwicklungstendenzen bei diskreten Transistoren unter besonderer Beachtung der Aufsetztechnik" * Seite 172, Absatz 3.2; Figur 7; Seite 172, Absatz 3.3 * | 2,6 | |
| | --- | | **RECHERCHIERTE SACHGEBIETE (Int. Cl.5)** |
| Y | US-A-4 556 896 (INTERNATIONAL RECTIFIER CORP.) * Spalte 3, Zeilen 22-33; Figur 7 * | 4 | H 01 L 23/00 |
| A | --- | 1,5 | |
| A | FR-A-2 110 575 (R.T.C. LA RADIOTECHNIQUE-COMPELEC) * Figur 2 * ----- | 1,3,5 | |

Der vorliegende Recherchenbericht wurde für alle Patentansprüche erstellt

| Recherchenort | Abschlußdatum der Recherche | Prüfer |
|---|---|---|
| DEN HAAG | 28-09-1990 | ZEISLER P.W. |